# EUROPEAN PATENT APPLICATION

(11) **EP 1 615 486 A1**
(43) Date of publication of application: **11.01.2006**
(21) Application number: 04254076.5
(22) Date of filing: 07.07.2004
(51) Int. Cl.: H05K 5/02, G06F 1/18

(54) **Safety detachable back panel**

(71) Applicant: Tatung Co., Ltd., Taipei City 104, R.O.C. (TW)
(72) Inventor: Song, Yew-Min, Taipei City 104 (TW)
(74) Representative: Tranter, Andrew David

(57) **Abstract**

A safety detachable back panel (120) mounted on the back surface (111) of a server (110) is disclosed, which comprises a panel body (121) having two plain holes (124), retaining mechanisms (130) adapted to secure the panel body to heat radiation vents (112) in the back surface of the server, two second screw-mounting holes (140) respectively aligned between the plain holes and two first screw-mounting holes (113) in the back surface of the server, and a lock unit (160) having a swivel sheet (161) capable of being turned by a key, wherein the swivel hook blocks the passages between the plain holes and the second screw-mounting holes, so the screws mounted on the second screw-mounting holes cannot be unauthorizedly accessed by a tool. As a result, the safety detachable back panel can protect the internal storage data and the connectors of the external data transmission devices.

## Description

### BACKGROUND OF THE INVENTION

### 1. Field of the Invention

The present invention relates to a safety detachable back panel and more particularly, to the safety detachable back panel at the back surface of a server.

### 2. Description of Related Art

The external data transmission devices of a conventional server, for example, a USB, DVD, FDD, etc. may be of a bad connection, or even of a complete connection failure to the server due to accidental collision.

Furthermore, due to a lack of a security mechanism, an unauthorized person may take importance storage devices away from the backside of the server, which may jeopardize the security of internal data.

Therefore, it is desirable to provide a safety detachable back panel that provides protection to the internal storage data of the server and the connectors of the external data transmission devices.

### SUMMARY OF THE INVENTION

The present invention has been accomplished under the circumstances in view. It is therefore the main object of the present invention to provide a simple and inexpensive protective back panel for a server to protect the backside of the server and the external data transmission devices, preventing damage to the surface of component parts during an impact of the server or disclosure of internal storage data.

To achieve this and other objects of the present invention, the safety detachable back panel adapted to a server, which has a plurality of through holes and at least one first screw-mounting hole at a back surface thereof, comprises: a panel body having a plurality of heat radiation vents, at least one input/output port hole, and at least one plain hole corresponding to the at least one first screw-mounting hole of the server; at least two retaining mechanisms connected to the through holes of the server to enable the panel body to cover the back surface of the server; at least one second screw-mounting hole corresponding to the first screw-mounting hole of the back surface of the server capable of being inserted by at least one screw passing through the at least one plain hole of the panel body in order to affix of the panel body to the back surface of the server; and a lock unit having a swivel sheet capable of being turned by a key, wherein the lock unit is located between the at least one second screw-mounting hole and the at least one plain hole of the panel body in a locking status and is away from the passage between the at least one plain hole of the panel body and the at least one second screw-mounting hole in an unlocking status.

The safety detachable back panel preferably has two retaining mechanisms mounted around the border area of the panel body in order to firmly fix the safety detachable back panel to the server. The retaining mechanisms and the panel body can be integrally formed to simplify the manufacture of the safety detachable back panel. The structure of the retaining mechanisms is not limited, but preferably is a hook. The through holes connected to the retaining mechanisms are heat radiation vents. The at least one first screw-mounting hole of the server is also preferably a heat radiation vent or is a screw-fixed hole on the back surface of the server designed for another purpose, for example, for fixing the slaver hard disk. The quantity of the input/output port holes of the panel body depends on the required function of the user. The quantity of the at least one first screw-mounting hole of the server, the quantity of the at least one plain hole of the panel body, and the quantity of the at least one second screw-mounting hole is set to 1 or 2.

### BRIEF DESCRIPTION OF THE DRAWINGS

FIG. 1 is an exploded view of the preferred embodiment of the present invention.
FIG. 2 is a schematic drawing showing the action of the lock unit of the safety detachable back panel according to the present invention.
FIG. 3 is a cross-sectional view showing the action of the lock unit of the safety detachable back panel according to the present invention.

### DETAILED DESCRIPTION OF THE PREFERRED EMBODIMENT

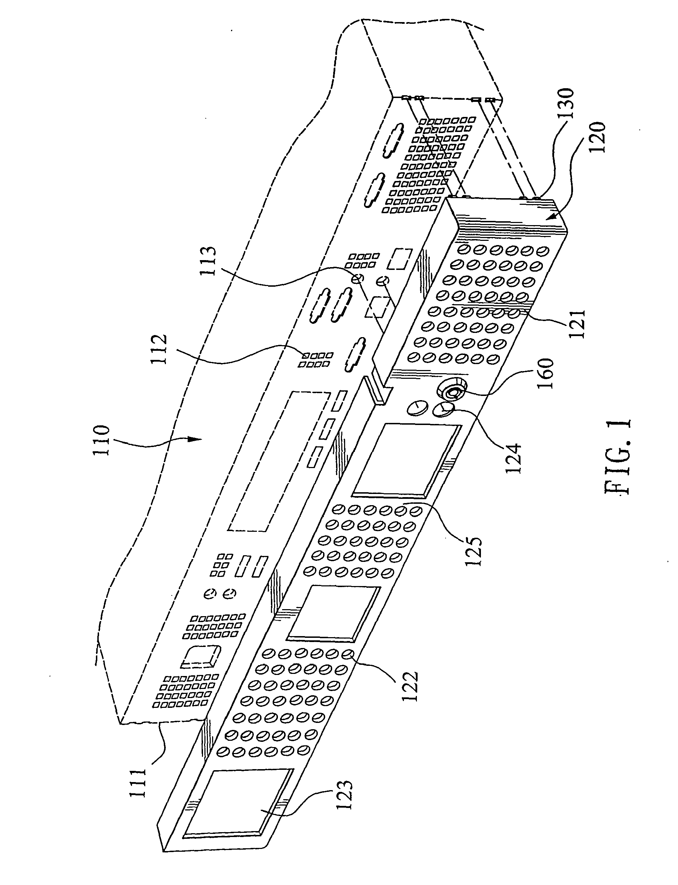

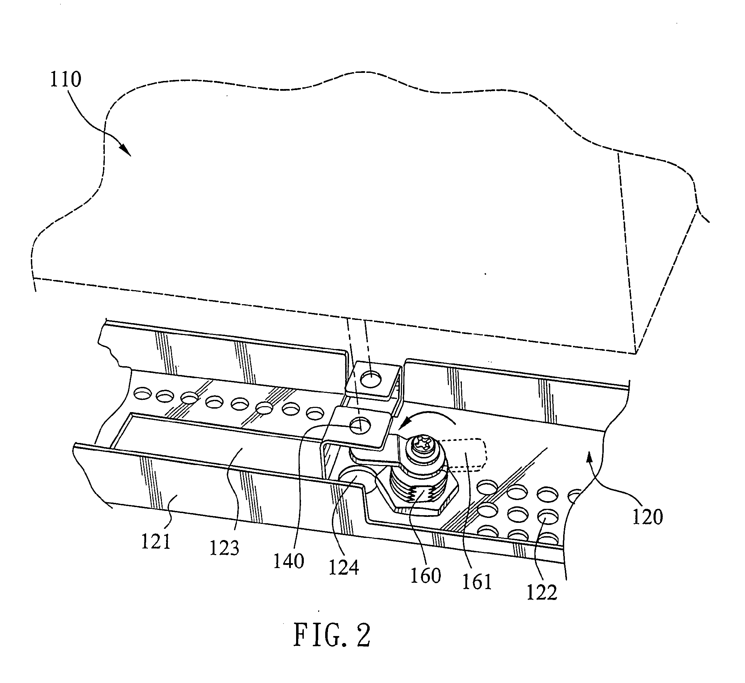

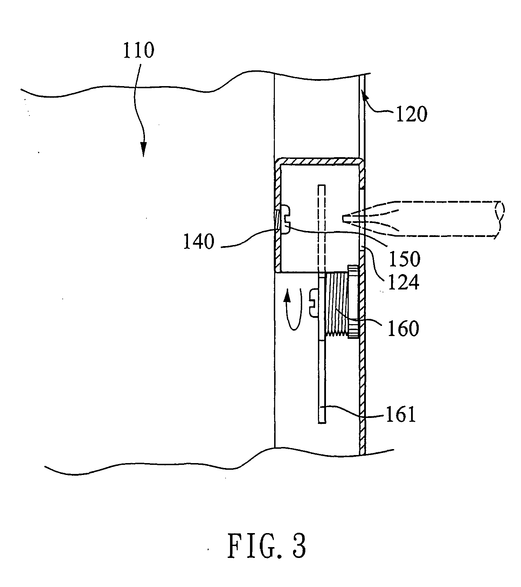

Referring to FIGS. 1~3, a safety detachable back panel **120** is installed on the back surface **111** of a server **110.** The back surface **111** of the server **110** comprises a plurality of heat radiation vents **112** and two first screw-mounting holes **113.** The safety detachable back panel **120** comprises a panel body **121,** four retaining mechanisms **130,** two second screw-mounting holes **140,** and a lock unit **160.** The panel body **121** comprises a plurality of heat radiation vents **122,** three I/O port holes **123,** and two plain holes **124** formed on the front surface **125** thereof. The plain holes **124** correspond to the first screw-mounting holes **113** in the back surface **111** of the server **110**. The retaining mechanisms **130** are hooks formed integral with the panel body **121** around the border area thereof for hooking in the heat radiation vents **112** in the back surface **111** of the server **110** to have the panel body **121** cover the back surface **111** of the server **110.** The two second screw-mounting holes **140** are formed integral with the panel body **121** and respectively attach to the first screw-mounting holes **113** in the back surface **111** of the server **110.** Screws **150** are respectively inserted through the plain hole **124,** and then mounted in the second screw-mounting holes **140,** meanwhile the screws **150** are threaded into the first screw-mounting holes **113** to fix the panel body **121** to the back surface **111** of the server **110.** The lock unit **160** is set in the panel body **121** of the safety back panel **120,** having a swivel sheet **161** controlled by a key. When locked, the swivel sheet **161** of the lock unit **160** is set in between the plain hole **124** and the second screw-mounting hole **140,** so a screwdriver cannot access the screws **150** fixed in the second screw-mounting holes **140.**

During installation of the safety detachable back panel **120,** the retaining mechanisms **130** are engaged in the heat radiation vents **112** in the back surface **111** of the server **110,** and then two screws **150** are respectively inserted through the plain holes **124** and then fastened to the second screw-mounting holes **140** and the first screw-mounting holes **113** to fix the panel body **121** to the back surface **111** of the server **110,** and then the key is used to turn the swivel sheet **161** to the locking position where the swivel sheet **161** conceals the screws **150.**

As indicated above, the inexpensive safety detachable back panel is easy to install. When installed in the back surface of the server, the safety detachable back panel gives a protection to the backside of the server, preventing disconnection of the connectors of external data transmission devices from the back surface of the server.

Although the present invention has been explained in relation to its preferred embodiment, it is to be understood that many other possible modifications and variations can be made without departing from the spirit and scope of the invention as hereinafter claimed.

## Claims

1. A safety detachable back panel adapted to a server, which has a plurality of through holes and at least one first screw-mounting hole at a back surface thereof, comprising:
a panel body having a plurality of first heat radiation vents, at least one input/output port hole, and at least one plain hole corresponding to the at least one first screw-mounting hole of the server;
at least two retaining mechanisms selectably connected to the through holes of the server whereby the panel body covers the back surface of the server;
at least one second screw-mounting hole corresponding to the first screw-mounting hole of the back surface of the server capable of being inserted by at least one screw extended through the at least one plain hole of the panel body in order to affix of the panel body to the back surface of the server; and
a lock unit having a swivel sheet capable of being turned by a key, wherein the lock unit is located between the at least one second screw-mounting hole and the at least one plain hole of the panel body in a locking status and is away from the passage between the at least one plain hole of the panel body and the at least one second screw-mounting hole in an unlocking status.

2. The safety detachable back panel as claimed in claim 1, wherein the at least two retaining mechanisms are formed around the border area of the panel body and are integrated with the panel body.

3. The safety detachable back panel as claimed in claim 1, wherein the at least two retaining mechanisms are hooks, which are selectably connected to the through holes of the server.

4. The safety detachable back panel as claimed in claim 3, wherein the through holes in the back surface of the server are second heat radiation vents.

5. The safety detachable back panel as claimed in claim 1, wherein the at least one first screw-mounting hole of the server each is a third heat radiation vent.

6. The safety detachable back panel as claimed in claim 1, wherein the quantity of the at least one first screw-mounting hole of the server, the quantity of the at least one plain hole of the panel body, and the quantity of the at least one second screw-mounting hole are each two.
